# EUROPEAN PATENT SPECIFICATION

(11) **EP 4 482 642 B1**
(45) Date of publication and mention of the grant of the patent: **01.04.2026**
(21) Application number: 23712714.7
(22) Date of filing: 22.02.2023
(51) Int. Cl.: B23K 20/00, B23K 20/233, H01L 23/00, H01M 50/296, H01M 50/50, H01M 50/516, B23K 101/38, B23K 101/42, B23K 103/10, B23K 103/12

(54) **WIRE BONDING APPARATUS WITH ACTIVE WIRE FEEDING FOR FORMING WIRE BONDS, CORRESPONDING METHOD**
DRAHTVERBINDUNGSVORRICHTUNG MIT AKTIVER DRAHTZUFÜHRUNG ZUR HERSTELLUNG VON DRAHTVERBINDUNGEN, UND ENTSPRECHENDES VERFAHREN
APPAREIL DE LIAISON DE FIL MÉTALLIQUE À UNE ALIMENTATION ACTIVE EN FIL MÉTALLIQUE DANS LA FORMATION DE LIAISONS FILAIRES, ET MÉTHODE CORRESPONDANTE

(30) Priority: 23.02.2022 US 202263268409 P
(43) Date of publication of application: 01.01.2025
(73) Proprietor: Atieva, Inc., Newark, CA 94560 (US)
(72) Inventor: FREY, Scott, P., Newark, California 94560 (US); CALPITO, DodgieReigh, M., Newark, California 94560 (US)
(74) Representative: Gulde & Partner
(86) International application number: PCT/US2023/063003
(87) International publication number: WO 2023/164468

(56) References cited:
- JP-A- S60 227 433
- KR-A- 20190 011 096
- US-A- 4 475 681
- US-A- 4 572 421
- US-A1- 2005 133 563

## Description

The present invention relates to active wire feeding in forming wire bonds, and in particular to a wire bonding apparatus and a method, see claims 1 and 8.

### BACKGROUND

In recent years, the world's transportation has begun a transition away from powertrains primarily driven by fossil fuels and toward more sustainable energy sources, chiefly among them electric motors powered by on-board energy storages. Vehicle makers are striving to increase efficiency and utility of such vehicles, including the performance of energy storages such as battery packs.

JP S60 227433 A (describing the preamble of claims 1 and 8) shows an ultrasonic wire bonding head, wherein ultrasonic waves are applied to a wedge for bonding a wire. A piezoelectric element is shrunk by applying a voltage thereto, whereby an arm is turned around an axis and rollers are separated from each other. The wedge is shifted to draw out the wire. The voltage applied to an element is turned off when the wedge descends to be bonded. The element is thereby returned to the original state and the arm is turned reversely so that the wire is clamped between the rollers. The wedge is lifted up in this condition. The roller is driven by a pulse motor upon cutting the wire so that further wire is delivered in accordance with the angle of rotation of the roller. The tip of the wire is presented to the tip of the wedge to prepare for the next bonding operation. US 4 572 421 A discloses an apparatus for supplying wire to a wire bonding mechanism. Lengths of wire are fed to a low mass wire-loop reservoir while the bonding process is taking place. Wire is then supplied, at a high speed, from the wire-loop reservoir for the next bonding operation. The amount of wire supplied is precisely measured by measuring the change in the amount of wire stored in the reservoir. US 2005/133563 A1 discloses a controller that may receive a wire disconnection signal from a wire bonding monitoring system and operate a wire clamp to clamp a disconnected wire. A series of operations, which may include a wire drawing operation, a wire tail forming operation and a ball forming operation, may be automatically performed. A sensor may measure the length of the wire drawn through the capillary and the location of a ball that may be formed at a wire tail. An auxiliary clamp may be installed between the wire clamp and the capillary for drawing the wire using sensor information.

### SUMMARY

In a first aspect of the present invention, a wire bonding apparatus is defined in claim 1, and comprises: a supply of bond wire; a first motor to advance the bond wire from the supply; a wedge to perform wirebonding by forming a first bond and a second bond, the second bond separated by a distance from the first bond; a wire guide adjacent the wedge for guiding the bond wire toward the wedge; and a second motor to advance the bond wire into the wire guide, the second motor configured to feed a length of the bond wire after formation of the first bond and before formation of the second bond, the length greater than the distance between the first and second bonds.

Implementations can include any or all of the following features. The wire bonding apparatus further comprises clamp for the bond wire. The clamp is positioned adjacent the wire guide, and wherein the second motor is positioned prior to the clamp in a direction that the bond wire is advanced from the supply. The second motor is positioned immediately before the clamp in the direction that the bond wire is advanced from the supply. The supply of bond wire comprises a spool. The second motor comprises at least two wheels opposing each other across the bond wire. The wire bonding apparatus further comprises a cutter to sever the bond wire.

In a second aspect of the present invention, a method is defined in claim 8, and comprises: positioning a bond wire at a first location on a substrate; forming, using a wire bonding head of a wire bonding machine, a first wire bond between the bond wire and the substrate at the first location; after forming the first wire bond, moving the wire bonding head from the first location to a second location on the substrate; while moving the wire bonding head, actively feeding, using a first motor of the wire bonding machine, a length of the bond wire through the wire bonding head, the length greater than a distance between the first and second locations; and forming, using a wire bonding head, a second wire bond between the bond wire and the substrate at the second location.

Implementations can include any or all of the following features. The method further comprises advancing, using a further motor of the wire bonding machine, the bond wire from a supply. The method further comprises coordinating operation of the motors. According to the present invention, the moving of the wire bonding head from the first location to the second location includes moving the wire bonding head perpendicularly to the substrate. The method further comprises severing the bond wire a cutter of the wire bonding machine.

### BRIEF DESCRIPTION OF DRAWINGS

FIG. 1 shows an example of a wire bonding machine that can be used in forming wire bonds.
FIG. 2 shows an example of a wire bonding head.
FIG. 3 shows an example of kink formation that can occur in the ribbon according to previous approaches of wire bonding.
FIG. 4 shows an example of actively feeding a wire in wire bonding according to the present disclosure.
FIG. 5 shows an example of a wire bond where a loop is formed between wire bonds.
FIG. 6 shows an example of a method.

Like reference symbols in the various drawings indicate like elements.

### DETAILED DESCRIPTION

The present disclosure describes examples of systems and techniques of simplifying and streamlining bond wire installation in battery modules by forming a bond wire that continues from a cell onto an intermediate busbar, and from there continues onto a next cell. This can be done between a pair of cells, or more than two cells arranged adjacent a busbar having the shape of a coplanar interleaved finger. The wire bonding machine can accomplish its task of building electrically conductive bonds more efficiently because it may not need to change direction (e.g., revert, or move sideways) as much as may be the case in most existing approaches.

Examples herein refer to forming a bond between two or more conductive materials. As used herein, a bond can be formed by any technique that joins the materials so that electric current can flow between them. Ultrasonic wirebonding and/or laser wirebonding can be used, to name just two examples. A presence of a bond between materials indicates that the materials are electrically coupled to each other, which is here referred to as them being coupled.

Examples herein refer to electrochemical cells. As used herein, an electrochemical cell is a device that generates electrical energy from chemical reactions, or uses electrical energy to cause chemical reactions, or both. An electrochemical cell can include an electrolyte and two electrodes to store energy and deliver it when used. In some implementations, the electrochemical cell can be a rechargeable cell. For example, the electrochemical cell can be a lithium-ion cell. In some implementations, the electrochemical cell can act as a galvanic cell when being discharged, and as an electrolytic cell when being charged. The electrochemical cell can have at least one terminal for each of the electrodes. The terminals, or at least a portion thereof, can be positioned at one end of the electrolytic cell. For example, when the electrochemical cell has a cylindrical shape, one of the terminals can be provided in the center of the end of the cell, and the can that forms the cylinder can constitute the other terminal and therefore be present at the end as well. Other shapes of electrochemical cells can be used, including, but not limited to, prismatic shapes.

Examples herein refer to a battery module, which is an individual component configured for holding and managing multiple electrochemical cells during charging, storage, and use. The battery module can be intended as the sole power source for one or more loads (e.g., electric motors), or more than one battery module of the same or different type can be used. Two or more battery modules can be implemented in a system separately or as part of a larger energy storage unit. For example, a battery pack can include two or more battery modules of the same or different type. A battery module can include control circuitry for managing the charging, storage, and/or use of electrical energy in the electrochemical cells, or the battery module can be controlled by an external component. For example, a battery management system can be implemented on one or more circuit boards (e.g., a printed circuit board).

Examples herein refer to a busbar, and a battery module can have at least one busbar. The busbar is electrically conductive and is used for conducting electricity to the electrochemical cells when charging, or from the cells when discharging. The busbar is made of an electrically conductive material (e.g., metal) and has suitable dimensions considering the characteristics of the electrochemical cells and the intended use. In some implementations, the busbar comprises aluminum (e.g., an aluminum alloy). A busbar can be planar (e.g., flat) or can have one or more bends, depending on the shape and intended use of the battery module. The busbar can be configured for placing electrochemical cells in a serial arrangement, or in a parallel arrangement, or in a serial and parallel arrangement.

Examples herein refer to bond wires (e.g., ribbon bond wires, or ribbon wires, or other electrical conductors). As used herein, a bond wire can have any number of different geometries, and can include one or more materials having respective conductivities. For instance, a bond wire can be a single layered bond wire, or can be a multi-layered bond wire that has a plurality of layers each having a respective conductivity. In some implementations, a bond wire can be a ribbon wire having a rectangular cross-section and having one or more layers. The one or more layers can include one or more electrically conductive materials, such as one or more metals and/or metal alloys. A bond wire can include, but is not limited to, copper, aluminum, a copper alloy, an aluminum alloy, and/or a combination thereof. As used herein, a bond wire being coupled to a surface (e.g., a conductive surface, electrical contact surface, etc.) refers to the bond wire being electrically and/or physically coupled with that surface, unless otherwise indicated.

Examples herein refer to a top or a bottom. These and similar expressions identify things or aspects in a relative way based on an express or arbitrary notion of perspective. That is, these terms are illustrative only, used for purposes of explanation, and do not necessarily indicate the only possible position, direction, and so on.

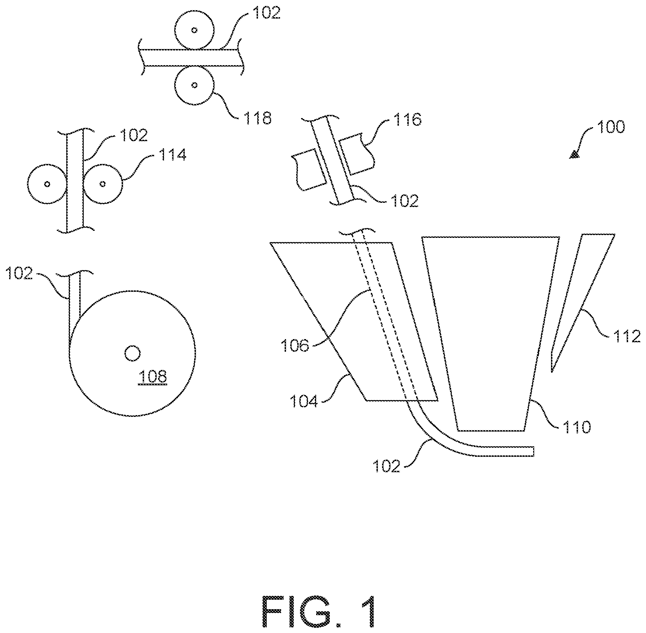

FIG. 1 shows an example of a wire bonding machine 100 that can be used in forming wire bonds. The wire bonding machine 100 can operate using a supply of bond wire 102. The wire bonding machine 100 and/or the bond wire 102 can be used with one or more other examples described elsewhere herein. The wire bonding machine 100 includes a wire guide 104. The wire guide 104 is used for guiding (e.g., feeding) the bond wire 102 in a bonding operation. The wire guide 104 can be made of one or more materials, including, but not limited to, a metal or a synthetic material. A supply 106 of the bond wire 102 is seen as passing through the wire guide 104. In some implementations, the supply 106 of the bond wire 102 can be provided from a spool 108. For example, the spool 108 can be rotatably suspended in relation to the wire bonding machine 100 so as to allow the supply 106 of the bond wire 102 to be obtained in a continuous or intermittent fashion, and such that the bond wire 102 has a particular orientation relative to an electrochemical cell for bonding.

The wire bonding machine 100 includes a wedge 110. The wedge 110 can be used to bond the bond wire 102 to an electrochemical cell (not shown). For example, the wedge 110 can be made of metal.

The wire bonding machine 100 includes a cutter 112. The cutter 112 can be used to sever the bond wire 102 before, during, or after bonding. For example, the cutter 112 can be made of metal.

The wire bonding machine 100 includes a motor 114. In some implementations, the motor 114 can be positioned relatively close to the spool 108 for help in unspooling the bond wire 102 from the spool 108. For example, the motor 114 can be the first motorized component of the wire bonding machine 100 that engages with the bond wire 102 upon the bond wire 102 leaving the spool 108 (e.g., the bond wire 102 can engage with one or more non-motorized wheels between the motor 114 and the spool 108). The motor 114 can be powered by electricity and can include one or more wheels (e.g., two opposing wheels) that engage with the bond wire 102 to advance the bond wire 102 in any direction. For example, the motor 114 can include at least two wheels opposing each other across the bond wire 102.

The wire bonding machine 100 can include a clamp 116. The clamp 116 can be actuated to engage with, and thereby immobilize or otherwise restrain, the bond wire 102 during some portion(s) of the wire bonding operation. For example, the clamp 116 can arrest the bond wire 102 during bonding performed by the wedge 110 and/or during cutting by the cutter 112. The clamp 116 can be actuated by electricity and can include one or more jaws (e.g., two opposing jaws) that engage with the bond wire 102 to restrict its movement in either direction.

The wire bonding machine 100 includes a motor 118. In some implementations, the motor 118 can be positioned relatively close to the wire guide 104 for help in advancing the bond wire 102 toward the wedge 110. For example, the motor 118 can be the last motor of the wire bonding machine 100 that advances the bond wire 102 before the wire guide 104 (e.g., the clamp 116 can be positioned between the motor 118 and the wire guide 104). In some implementations, the clamp 116 is positioned adjacent the wire guide 104, and the motor 118 is positioned upstream of the clamp 116. For example, the motor 118 can be positioned prior to the clamp 116 in a direction that the bond wire 102 is advanced from the spool 108. The motor 118 can be positioned immediately before the clamp 116 in the direction that the bond wire 102 is advanced from the spool 108.

The motor 118 can be powered by electricity and can include one or more wheels (e.g., two opposing wheels) that engage with the bond wire 102 to advance the bond wire 102 in any direction. For example, the motor 118 can include at least two wheels opposing each other across the bond wire 102.

The wire bonding machine 100 can coordinate the operation of the motors 114 and 118. In some implementations, the coordination can seek to avoid stress or tension in the bond wire 102. For example, the motor 114 can advance the bond wire 102 from the spool 108 with some slack, and then the motor 118 can feed the bond wire 102, with benefit of the slack, through the wire guide 104.

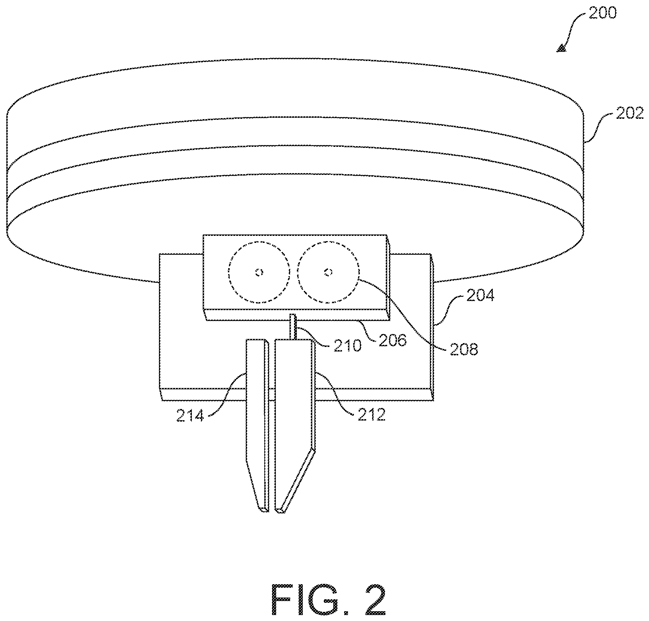

FIG. 2 shows an example of a wire bonding head 200, which is part of the wire bonding machine 100 in FIG. 1. The wire bonding head 200 includes a rotation stage 202 that can control the orientation of bond formation relative to a workpiece (not shown), which can include one or more substrates. The rotation stage 202 can include any mechanism for actuating rotation of a wire bonding stage 204 relative to the workpiece. The wire bonding head 200 can be used for wire bond formation on substrates of any type of electric or electronic apparatus, including, but not limited to, to forming wire bonds between a busbar of a battery module and one or more terminals of individual cells. The mechanism of the rotation stage 202 can be actuated by way of gears, a belt drive, or electromagnetic actuation, to name just a few examples.

The wire bonding stage 204 can include a motor 206 that can drive at least one wheel 208. For example, the motor 206 can include at least two wheels 208 opposing each other across a bond wire 210 that is being used by the wire bonding head 200 in wire bonding. The wheels(s) 208 can engage with and thereby advance the bond wire 210. The present illustration shows the bond wire 210 emerging from the motor 206 and entering into a wire guide 212 that is part of the wire bonding stage 204. The bond wire 210 can then emerge from an opposite end of the wire guide 212 and can be acted on using a wedge 214 that is also part of the wire bonding stage 204. In some implementations, a clamp (not shown) can be used. For example, the clamp is positioned before or after the motor 206 in the advancement direction of the bond wire 210.

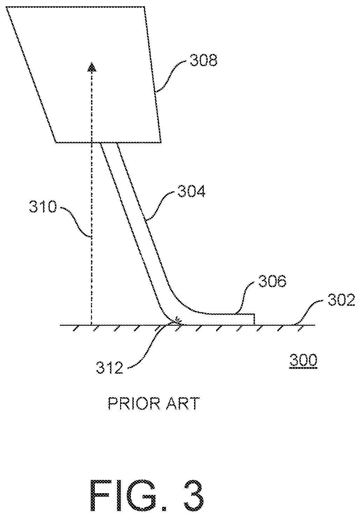

FIG. 3 shows an example of kink formation that can occur in the ribbon according to previous approaches of wire bonding. Here, a substrate 300 is schematically shown as including a surface 302. A bond wire 304 is being used for the wire bonding. Here, a wire bond 306 has been formed at an end of the bond wire 304. The bond wire 304 emerges from a wire guide 308 that may be part of an apparatus (not shown) used in the wire bonding. When the wire bond 306 has been formed, the wire guide 308 may be moved to a different location of the substrate 300. In so doing, the wire guide 308 may be moved perpendicularly to the surface 302 of the substrate 300, as schematically illustrated by an arrow 310. In such movement (e.g., perpendicular movement), a kink 312 may be formed in the bond wire 304 adjacent the wire bond 306. In some implementations, the kink 312 may be formed where the bond wire 304 departs from the surface 302. For example, the kink 312 may be a common failure point in previous approaches of wire bonding.

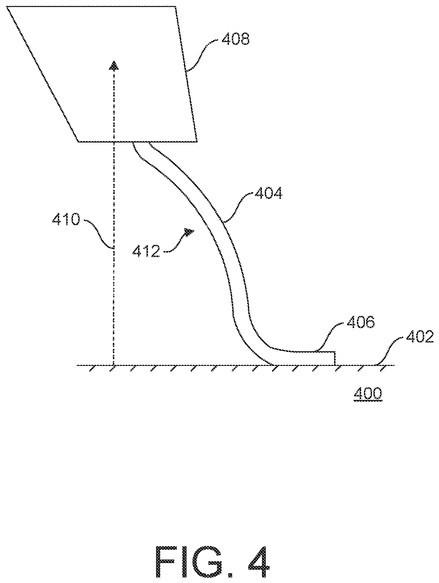

FIG. 4 shows an example of actively feeding a wire in wire bonding according to the present invention. Here, a substrate 400 is schematically shown as including a surface 402. A bond wire 404 is being used for the wire bonding. The wire bonding of the present example can be performed using one or more other examples described elsewhere herein. Here, a wire bond 406 has been formed at an end of the bond wire 404. The bond wire 404 emerges from a wire guide 408 that may be part of an apparatus (not shown) used in the wire bonding. For example, any wire bonding head and/or wire bonding machine described elsewhere herein can be used. When the wire bond 406 has been formed, the wire guide 408 is moved to a different location of the substrate 400. In so doing, the wire guide 408 is moved perpendicularly to the surface 402 of the substrate 400, as schematically illustrated by an arrow 410. During such movement, the bond wire 404 is actively fed through the wire guide 408 using at least one motor. For example, the active feeding ensures that a slack 412 is created in the bond wire 404 between the wire guide 408 and the wire bond 406. With such active feeding of the bond wire 404, kinking in the bond wire 404 can be reduced or avoided. For example, a failure point of bond formation can thereby be eliminated.

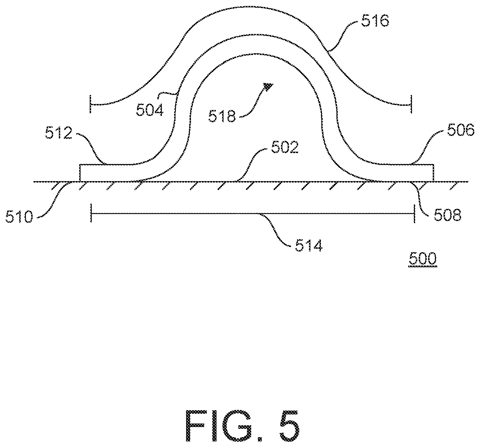

FIG. 5 shows an example of a wire bond where a loop is formed between wire bonds. The wire bonding of the present example can be performed using one or more other examples described elsewhere herein. Here, a substrate 500 is schematically shown as including a surface 502. A bond wire 504 has been used for the wire bonding. The wire bonding of the present example can be performed using one or more other examples described elsewhere herein. Here, a wire bond 506 has been formed at an end of the bond wire 504 at a location 508 on the surface 502. Any wire bonding head and/or wire bonding machine described elsewhere herein can be used. After the wire bond 506 was formed, a wire guide was moved to a location 510 on the surface 502. Then, a wire bond 512 was formed at the location 510. The bond wire 504 was actively fed during at least part of the bond formation process. The bond wire 504 may be severed from a remaining bond wire supply before, during, or after the wire bond 512 is formed.

The locations 508 and 510 are separated by a distance 514 on the surface 502 of the substrate 500. The active feeding of the bond wire 504, moreover, causes the bond wire 504 to have a length 516 which is greater than the distance 514. As such, the bond wire 504 has a curvature 518 which can be characterized as a slack or loop in the bond wire 504 between the wire bonds 506 and 512. That is, due to the curvature 518 the bond wire 504 does not merely extend in a straight line from the wire bond 506 to the wire bond 512. The curvature 518 can reduce or avoid kinking in the bond wire 504. For example, a failure point of bond formation can thereby be eliminated.

Examples described herein illustrate that a wire bonding apparatus (e.g., the wire bonding machine 100 in FIG. 1) can include a supply of bond wire (e.g., the spool 108 and the bond wire 102 in FIG. 1); a first motor (e.g., the motor 114 in FIG. 1) to advance the bond wire from the supply; a wedge (e.g., the wedge 110 in FIG. 1) to perform wirebonding by forming a first bond (e.g., the wire bond 506 in FIG. 5) and a second bond (e.g., the wire bond 512 in FIG. 5), the second bond separated by a distance (e.g., the distance 514) from the first bond; a wire guide (e.g., the wire guide 212 in FIG. 2) adjacent the wedge for guiding the bond wire toward the wedge; and a second motor (e.g., the motor 118 in FIG. 1 or the motor 206 in FIG. 2) to advance the bond wire into the wire guide. The second motor is configured to feed a length of the bond wire (e.g., the length 516 in FIG. 5) after formation of the first bond and before formation of the second bond. The length is greater than the distance between the first and second bonds (e.g., the length 516 is greater than the distance 514).

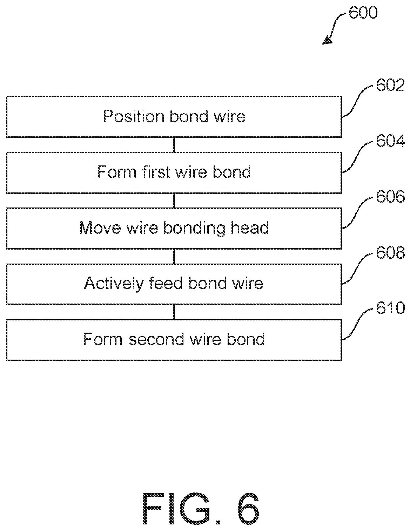

FIG. 6 shows an example of a method 600. The method 600 can be used with one or more other examples described elsewhere herein. More or fewer operations than shown can be performed. Two or more operations can be performed in a different order unless otherwise indicated.

At operation 602, the method 600 can include positioning a bond wire at a first location on a substrate. For example, the bond wire 504 in FIG. 5 can be positioned at the location 508.

At operation 604, the method 600 can include forming, using a wire bonding head of a wire bonding machine, a first wire bond between the bond wire and the substrate at the first location. For example, the wire bond 506 in FIG. 5 can be formed.

At operation 606, the method 600 can include, after forming the first wire bond, moving the wire bonding head from the first location to a second location on the substrate. For example, the wire bonding head 200 in FIG. 2 can be moved from the location 508 in FIG. 5 to the location 510.

At operation 608, the method 600 can include, while moving the wire bonding head, actively feeding, using a first motor of the wire bonding machine, a length of the bond wire through the wire bonding head, the length greater than a distance between the first and second locations. For example, the bond wire 504 in FIG. 5 can be fed the length 516.

At operation 610, the method 600 can include forming, using a wire bonding head, a second wire bond between the bond wire and the substrate at the second location. For example, the wire bond 512 in FIG. 5 can be formed.

A number of implementations have been described. Nevertheless, it will be understood that various modifications may be made without departing from the scope of the present invention as defined in the appended claims.

## Claims

1. A wire bonding apparatus (100) comprising:
a supply (106) of bond wire (102);
a first motor (114) to advance the bond wire (102) from the supply (106);
a wedge (110) to perform wirebonding by forming a first bond (506) and a second bond (512) on a surface (502) of a substrate (500), the second bond (512) separated by a distance from the first bond (506); and
a wire guide (104) adjacent the wedge (110) for guiding the bond wire (102) toward the wedge (110);
**characterized by**
a second motor (118) configured, in use, to advance the bond wire (102) into the wire guide (104) while moving (606) the wire guide (104) perpendicular to the surface (502) of the substrate (500), the second motor (118) configured to feed a length (516) of the bond wire (102) after formation of the first bond (506) and before formation of the second bond (512), the length (516) greater than the distance (514) between the first and second bonds (506, 512).

2. The wire bonding apparatus (100) of claim 1, further comprising a clamp (116) for the bond wire (102).

3. The wire bonding apparatus (100) of claim 2, wherein the clamp (116) is positioned adjacent the wire guide (104), and wherein the second motor (118) is positioned prior to the clamp (116) in a direction that the bond wire (102) is advanced from the supply (106).

4. The wire bonding apparatus (100) of claim 3, wherein the second motor (118) is positioned immediately before the clamp (116) in the direction that the bond wire (102) is advanced from the supply (106).

5. The wire bonding apparatus (100) of claim 1, wherein the supply (106) of bond wire (102) comprises a spool (108).

6. The wire bonding apparatus (200) of any preceding claim, wherein the second motor (206) comprises at least two wheels (208) opposing each other across the bond wire (210).

7. The wire bonding apparatus (100) of any preceding claim, further comprising a cutter (112) to sever the bond wire (102).

8. A method comprising:
positioning (602) a bond wire (504) at a first location on a substrate (500);
forming (604), using a wire bonding head (200) of a wire bonding machine (100), a first wire bond (506) between the bond wire (504) and the substrate (500) at the first location (508); and
after forming (604) the first wire bond (506), moving (606) the wire bonding head (200) from the first location (508) to a second location (510) on the substrate (500);
**characterized by**
while moving (606) the wire bonding head (200) perpendicular to a surface (502) of the substrate (500), actively feeding (608), using a motor (118) of the wire bonding machine (100), a length of the bond wire (504) through the wire bonding head (200), the length (516) greater than a distance (514) between the first and second locations (508, 510); and
forming (610), using a wire bonding head (200), a second wire bond (512) between the bond wire (504) and the substrate (500) at the second location (510).

9. The method of claim 8, further comprising advancing, using a further motor (114) of the wire bonding machine (100), the bond wire (504) from a supply (106).

10. The method of claim 9, further comprising coordinating operation of the motors (118, 114).

11. The method of any of claims 8-10, wherein moving (606) the wire bonding head (200) from the first location (508) to the second location (510) includes moving the wire bonding head (200) perpendicularly to the substrate (500).

12. The method of any of claims 8-11, further comprising severing the bond wire (504) using a cutter (112) of the wire bonding machine (100).

## Patentansprüche

1. Drahtverbindungsvorrichtung (100), umfassend:
einen Vorrat (106) an Verbindungsdraht (102);
einen ersten Motor (114) zum Vorschieben des Verbindungsdrahts (102) aus dem Vorrat (106);
einen Keil (110) zum Durchführen einer Drahtverbindung durch Bilden einer ersten Verbindung (506) und einer zweiten Verbindung (512) auf einer Fläche (502) eines Substrats (500), wobei die zweite Verbindung (512) durch einen Abstand von der ersten Verbindung (506) getrennt ist; und
eine Drahtführung (104) angrenzend an den Keil (110) zum Führen des Verbindungsdrahts (102) in Richtung des Keils (110);
**gekennzeichnet durch**
einen zweiten Motor (118), der im Gebrauch so konfiguriert ist, dass er den Verbindungsdraht (102) in die Drahtführung (104) vorschiebt, während die Drahtführung (104) senkrecht zur Fläche (502) des Substrats (500) bewegt wird (606), wobei der zweite Motor (118) so konfiguriert ist, dass er eine Länge (516) des Verbindungsdrahts (102) nach der Bildung der ersten Verbindung (506) und vor der Bildung der zweiten Verbindung (512) zuführt, wobei die Länge (516) größer ist als der Abstand (514) zwischen der ersten und zweiten Verbindung (506, 512).

2. Drahtverbindungsvorrichtung (100) nach Anspruch 1, ferner umfassend eine Klemme (116) für den Verbindungsdraht (102).

3. Drahtverbindungsvorrichtung (100) nach Anspruch 2, wobei die Klemme (116) angrenzend an die Drahtführung (104) positioniert ist und wobei der zweite Motor (118) in einer Richtung, in der der Verbindungsdraht (102) aus dem Vorrat (106) vorgeschoben wird, vor der Klemme (116) positioniert ist.

4. Drahtverbindungsvorrichtung (100) nach Anspruch 3, wobei der zweite Motor (118) in der Richtung, in der der Verbindungsdraht (102) aus dem Vorrat (106) vorgeschoben wird, unmittelbar vor der Klemme (116) positioniert ist.

5. Drahtverbindungsvorrichtung (100) nach Anspruch 1, wobei der Vorrat (106) an Verbindungsdraht (102) eine Spule (108) umfasst.

6. Drahtverbindungsvorrichtung (200) nach einem der vorhergehenden Ansprüche, wobei der zweite Motor (206) mindestens zwei Räder (208) umfasst, die sich über den Verbindungsdraht hinweg (210) gegenüberstehen.

7. Drahtverbindungsvorrichtung (100) nach einem der vorhergehenden Ansprüche, ferner umfassend eine Schneideinrichtung (112) zum Durchtrennen des Verbindungsdrahts (102).

8. Verfahren, umfassend:
Positionieren (602) eines Verbindungsdrahtes (504) an einer ersten Stelle auf einem Substrat (500);
Bilden (604), unter Verwendung eines Drahtverbindungskopfes (200) einer Drahtverbindungsmaschine (100), einer ersten Drahtverbindung (506) zwischen dem Verbindungsdraht (504) und dem Substrat (500) an der ersten Stelle (508); und
nach dem Bilden (604) der ersten Drahtverbindung (506), Bewegen (606) des Drahtverbindungskopfes (200) von der ersten Stelle (508) zu einer zweiten Stelle (510) auf dem Substrat (500);
**gekennzeichnet durch**
während des Bewegens (606) des Drahtverbindungskopfes (200) senkrecht zu einer Fläche (502) des Substrats (500), aktives Zuführen (608), unter Verwendung eines Motors (118) der Drahtverbindungsmaschine (100), einer Länge des Verbindungsdrahtes (504) durch den Drahtverbindungskopf (200), wobei die Länge (516) größer ist als ein Abstand (514) zwischen der ersten und der zweiten Stelle (508, 510); und
Bilden (610), unter Verwendung eines Drahtverbindungskopfes (200), einer zweiten Drahtverbindung (512) zwischen dem Verbindungsdraht (504) und dem Substrat (500) an der zweiten Stelle (510).

9. Verfahren nach Anspruch 8, ferner umfassend Vorschieben, unter Verwendung eines weiteren Motors (114) der Drahtverbindungsmaschine (100), des Bonddrahtes (504) aus einem Vorrat (106).

10. Verfahren nach Anspruch 9, ferner umfassend Koordinieren des Betriebs der Motoren (118, 114).

11. Verfahren nach einem der Ansprüche 8-10, wobei das Bewegen (606) des Drahtverbindungskopfes (200) von der ersten Stelle (508) zu der zweiten Stelle (510) Bewegen des Drahtverbindungskopfes (200) senkrecht zu dem Substrat (500) beinhaltet.

12. Verfahren nach einem der Ansprüche 8-11, ferner umfassend Durchtrennen des Verbindungsdrahtes (504) unter Verwendung einer Schneideinrichtung (112) der Drahtverbindungsmaschine (100).

## Revendications

1. Dispositif de liaison de fil (100), comprenant :
une amenée (106) de fil de liaison (102) ;
un premier moteur (114) pour faire avancer le fil de liaison (102) à partir de l'amenée (106) ;
une cale (110) pour réaliser la liaison de fil en formant une première liaison (506) et une deuxième liaison (512) sur une surface (502) d'un substrat (500), la deuxième liaison (512) étant séparée par une distance de la première liaison (506) ; et
un guide-fil (104) adjacent à la cale (110) pour guider le fil de liaison (102) vers la cale (110) ;
**caractérisé par**
un deuxième moteur (118) configuré, en utilisation, pour faire avancer le fil de liaison (102) dans le guide-fil (104) tout en déplaçant (606) le guide-fil (104) perpendiculairement à la surface (502) du substrat (500), le deuxième moteur (118) étant configuré pour faire avancer une longueur (516) du fil de liaison (102) après la formation de la première liaison (506) et avant la formation de la deuxième liaison (512), la longueur (516) étant supérieure à la distance (514) entre la première et deuxième liaisons (506, 512).

2. Dispositif de liaison de fil (100) de la revendication 1, comprenant en outre une pince (116) pour le fil de liaison (102).

3. Dispositif de liaison de fil (100) de la revendication 2, dans lequel la pince (116) est positionnée de manière adjacente au guide-fil (104), et dans lequel le deuxième moteur (118) est positionné en amont de la pince (116) dans une direction dans laquelle le fil de liaison (102) est avancé à partir de l'amenée (106).

4. Dispositif de liaison (100) de la revendication 3, dans lequel le deuxième moteur (118) est positionné immédiatement avant la pince (116) dans la direction dans laquelle le fil de liaison (102) est fait avancer à partir de l'amenée (106).

5. Dispositif de liaison (100) de la revendication 1, dans lequel l'amenée (106) de fil de liaison (102) comprend une bobine (108).

6. Dispositif de liaison (200) de toute revendication précédente, dans lequel le deuxième moteur (206) comprend au moins deux roues (208) s'opposant l'une à l'autre à travers le fil de liaison (210).

7. Dispositif de liaison par fil (100) de toute revendication précédente, comprenant en outre un cutter (112) pour couper le fil de liaison (102).

8. Procédé comprenant :
positionner (602) un fil de liaison (504) au niveau d'une première position sur un substrat (500) ;
former (604), à l'aide d'une tête de liaison de fil (200) une machine de liaison de fil (100), une première liaison de fil (506) entre le fil de liaison (504) et le substrat (500) au niveau de la première position (508) ; et
après avoir formé (604) le premier fil de liaison (506), déplacer (606) la tête de fil de liaison (200) de la première position (508) à une deuxième position (510) sur le substrat (500) ;
**caractérisé par**
tout en déplaçant (606) la tête de fil de liaison (200) perpendiculairement à une surface (502) du substrat (500), alimenter activement (608), à l'aide d'un moteur (118) de la machine de liaison de fil (100), une longueur du fil de liaison (504) à travers la tête de liaison de fil (200), la longueur (516) étant supérieure à une distance (514) entre la première et deuxième positions (508, 510) ; et
former (610), à l'aide d'une tête de liaison de fil (200), une deuxième liaison de fil (512) entre le fil de liaison (504) et le substrat (500) au niveau de la deuxième position (510).

9. Procédé de la revendication 8, comprenant en outre faire avancer, à l'aide d'un autre moteur (114) de la machine de liaison de fil (100), le fil de liaison (504) à partir d'une amenée (106).

10. Procédé de la revendication 9, comprenant en outre coordonner le fonctionnement des moteurs (118, 114).

11. Procédé de l'une quelconque des revendications 8 à 10, dans lequel le déplacement (606) de la tête de liaison de fil (200) de la première position (508) à la deuxième position (510) comprend le déplacement de la tête de liaison de fil (200) perpendiculairement au substrat (500).

12. Procédé de l'une quelconque des revendications 8 à 11, comprenant en outre sectionner le fil de liaison (504) à l'aide d'un cutter (112) de la machine de liaison de fil (100).
